# EUROPEAN PATENT SPECIFICATION

(11) **EP 3 691 890 B1**
(45) Date of publication and mention of the grant of the patent: **15.09.2021**
(21) Application number: 18779731.1
(22) Date of filing: 08.10.2018
(51) Int. Cl.: B32B 15/04, B32B 15/08, B32B 15/085, B32B 15/088, B32B 15/09, B32B 15/20, B32B 27/30, B32B 27/32, B32B 27/34, B32B 27/36, H01L 31/048, H01L 31/02, H01L 31/0224, H01L 31/05

(54) **ELECTRO-CONDUCTIVE BACK-SHEET COMPRISING AN ALUMINIUM AND A METAL LAYER**
ELEKTROLEITFÄHIGE RÜCKWANDFOLIE MIT EINER ALUMINIUM- UND EINER METALLSCHICHT
FEUILLE SUPPORT ÉLECTROCONDUCTRICE COMPRENANT UNE COUCHE D'ALUMINIUM ET DE MÉTAL

(30) Priority: 06.10.2017 EP 17195176
(43) Date of publication of application: 12.08.2020
(73) Proprietor: DSM Advanced Solar B.V., 6167 RD Geleen (NL)
(72) Inventor: VAN DUIJNHOVEN, Franciscus Gerardus Henricus, 6100 AA Echt (NL); JANSSEN, Robert, 6100 AA Echt (NL)
(74) Representative: DSM Intellectual Property
(86) International application number: PCT/EP2018/077348
(87) International publication number: WO 2019/068934

(56) References cited:
- EP-A2- 1 302 988
- EP-A2- 2 109 137
- WO-A1-2014/182165
- WO-A1-2016/046293
- US-A1- 2009 151 773

## Description

The present invention relates to an electro-conductive back-sheet comprising an aluminum layer and a metal layer for back contact photovoltaic cell technology. The invention further relates to a process for the manufacturing of the electro-conductive back-sheet and to a photovoltaic module comprising the electro-conductive back-sheet.

Photovoltaic modules, serve for electrical power generation from sunlight and consist of a laminate which comprises a solar cell system as the core layer. This core layer is encapsulated with encapsulation materials which serve as protection against mechanical and weathering-related influences. In conventional photovoltaic modules or solar modules, the active solar cell is positioned between a front side and a back side. The front side is transparent, generally consists of glass; and is bonded by means of an encapsulant layer which for example contains an ethylene-vinyl acetate copolymer to the layer comprising the solar cell. The back side provides electric shielding, serves as protection against weathering influences such as UV light and acts as a moisture and oxygen barrier. Typical back-side materials include, for example, a polymeric or glass sheet. Polymeric back-side materials (often referred to as "back-sheets") typically include at least one layer including a fluoropolymer and multiple other layers including polymers such as polyesters (e.g., polyethylene terephthalate (PET) polymers, polyethylene naphthalate (PEN) polymers), or polyamides. For example, US2008/0216889 and US7638186 describe a back-sheet including PET.

Photovoltaic modules comprising EWT (emitter-wrap-through) or MWT (metal-wrap-through) or IBC (interdigitated back-contact) solar cells can comprise a conductive patterned back sheet for contacting the electrical contacts on the rear surface of the solar cells. Typically, such a back sheet comprises a polymer layer and a patterned conductive layer made of copper (or copper alloy). For connection of a junction box at the back of the module, the polymer layer at the rear side of the module should be locally opened and tabs from the junction box soldered to the conductive layer. However, the cost of copper is relatively high and presents a bottleneck for implementation of the photovoltaic modules in industry.

Alternatives have been considered such as an aluminum based electro-conductive layer, since aluminum is comparatively cheap. However, soldering solar cell contacts or junction box contacts to aluminum is cumbersome, since the wettability of aluminum by the solder is usually poor, yielding poor and relatively unreliable electrical interconnections. Also, a high contact resistance on aluminum is observed when an electro-conductive adhesive is used to connect a solar cell contact to the aluminum conductive layer. To solve these difficulties, prior art aluminum conductive layers on back sheets have been covered by vacuum deposition of a metal layer with better properties for using electro-conductive adhesive on aluminum. The metal layer is for example a copper layer. For example, Hanita Coatings offers a commercially available highly conductive aluminium laminate, comprising a copper skin exterior coating. The coating is typically applied via traditional thermal spray technologies whereby thermal energy is used to melt or soften the metal. A disadvantage is that this may cause thermal degradation and partial oxidation of the metal which may be undesirable. Another disadvantage is that the use of more dissimilar metals such as Al and Cu provide a potential for contact corrosion. For this type of corrosion to take place, four things must exist simultaneously: an anode, a cathode, an electrolyte and direct [=galvanic] contact between the two types of metal. In PV installations, the anode and cathode consist of metals, such as stainless steel, copper and aluminum. Water and dissolved "contamination", that may originate from encapsulant degradation, commonly serves as the electrolyte that enables galvanic corrosion to occur. As humidity increases, so does the rate of corrosion.

A further disadvantage is that when highly conductive aluminium laminate, comprising a copper skin exterior coating, is applied on a back-sheet with a high oxygen transmission rate (OTR), it drives up the resistances of the contacts between the metal layer and the electro-conductive adhesive (ECA) to unacceptable values upon damp heat ageing at 85°C/85% Relative Humidity (RH). Due to the increase in the resistance of the contact between the metal layer and ECA, the power output of the photovoltaic module decreases. It is therefore preferred that the polymeric back-sheet is composed of polymers that have a low oxygen transmission rate such that the OTR of the back-sheet is below 20 cm3/m2.atm per day. A disadvantage is however that back-sheets with a low OTR are usually composed of polymers possessing a decreased hydrolytic resistance and UV stability which will also decrease the mechanical properties upon ageing and hence during lifetime. WO2014/182165 A1 describes a back-sheet of a solar panel comprising an aluminium layer cold-sprayed with a second conductive metal on a polymer back side material. No OTR specification of the polymer is mentioned.

The object of the present invention is to solve the above-mentioned problems and to provide a photovoltaic module comprising an electroconductive back-sheet comprising an aluminium-metal layer with a reduced power output decay upon damp heat ageing. Another object of the present invention is to provide a photovoltaic module comprising the electro-conductive back-sheet with less corrosion sensitivity. A further object of the present invention is to provide a photovoltaic module comprising an electro-conductive back-sheet with good chemical and electrical durability and thus good mechanical properties.

The objects have been achieved in that an electro-conductive back-sheet is provided comprising an aluminium layer, a cold sprayed metal layer on top of the aluminum layer, and a polymeric backsheet wherein the polymeric back-sheet has an OTR of at least 20 cm3/m2.atm per day.

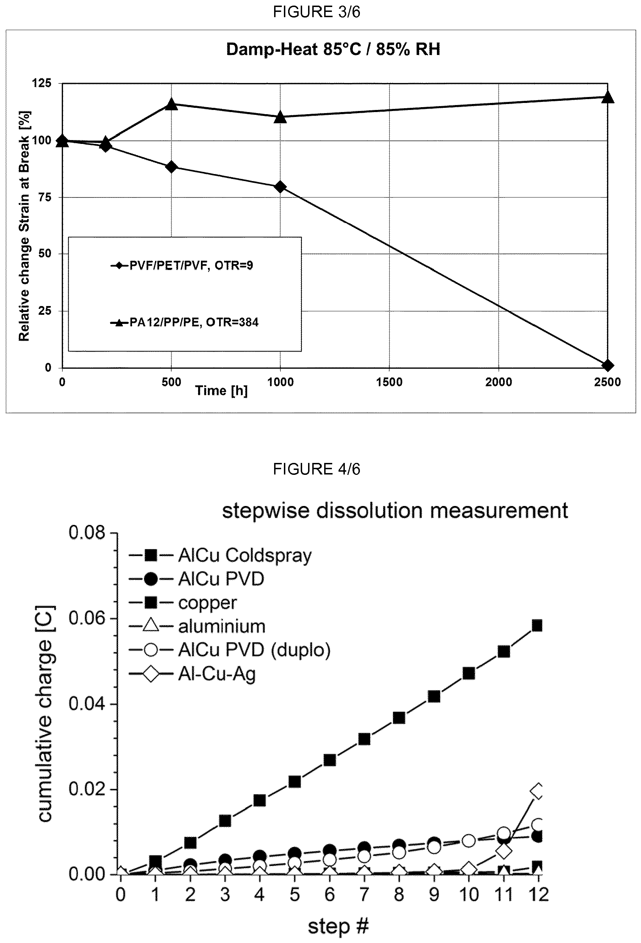

It has surprisingly been found that a module comprising the electro-conductive back-sheet comprising an aluminum layer and a cold sprayed metal layer results in reduced power output decay upon damp heat ageing. It has moreover been found that the mechanical properties of the back-sheet remain status quo/ stable over time in case a back-sheet is used with an OTR of at least 20 cm3/m2.atm per day as shown in Figure 3). The electro-conductive back-sheet according to the present invention thus provides good electrically and chemical properties such that the mechanical properties also remain if used in photovoltaic modules.

Module output decay is typically assessed with a Damp Heat Test, followed by an IV characterization (see examples 2-5). Moreover, this test provides a means to accelerate the ageing of the back-sheets in 85°C and 85 % relative humidity (RH) environment and typically the module is removed at 500 hrs, 1000 hrs and 2500 hrs and 3000 hrs and checked for first evidence of cracking. Using a light table, the laminated structures are inspected for cracks in the layers. If no cracks are visible at a given interval, it is considered to pass the test. If a crack is visible at a given interval, it is considered to fail the test.

Also surprising is the fact that corrosion sensitivity of the photovoltaic module comprising the electro conductive back-sheet according to the present invention is decreased although it is known that back-sheets with higher OTR values such as an OTR of at least 20 cm3/m2.atm per day transmit more oxygen, i.e., more oxygen would be available for the corrosion of the metal layer. In the present invention, the polymeric back-sheet may have an OTR of at least 40 cm3/m2.atm per day, preferably of at least 60 cm3/m2.atm per day, more preferably at least 240 cm3/m2.atm per day.

OTR (oxygen transmission rate) as used herein means the steady state rate at which oxygen gas permeates through a film at specified conditions of temperature and relative humidity (RH). OTR values are expressed in cm3/m2.atm per day in metric (or SI) units. In general, oxygen permeation measurements of thermoplastics polymeric layers in formulated back-sheets are performed according to ASTM D 3985 with a MOCON OX-Tran 2/21 at 38°C, 0% RH, area of the back-sheet samples 50 cm2. Examples of oxygen and water permeation numbers of several polymeric materials can be found in Packaging technology and Science 2003;16:149-158, or in Food contact polymeric Materials, review (ISSN:0889-3144)-RAPRA technology Ltd., 1992.

The polymeric back-sheet as mentioned herein means a back-sheet that is composed of at least one polymeric layer. In the case that one polymeric layer is present, the back-sheet is called a monolayer back-sheet. In the case that more polymeric layers are present, the back-sheet is called a multilayer back-sheet. The electro-conductive back-sheet preferably comprises at least 2 and up to 8 polymeric layers.

The polymeric layer(s) as mentioned herein comprise thermoplastic or thermosetting polymers. A thermoplastic polymer is a polymer that becomes pliable or moldable above a specific temperature and solidifies upon cooling. Thermoplastics differ from thermosetting polymers in that thermosetting polymers form irreversible chemical bonds during a curing process. Thermosets do not melt but decompose and do not reform upon cooling. Thermoplastic polymer layers are preferred.

Oxygen- and water permeation of a thermoplastic polymeric layer(s) can be modeled by the use of a permeation calculation by in-series connection of individual polymeric layers with individual resistances for mass transport. OTR of a back-sheet is governed by the Oxygen permeabilities P1, P2,.. (in cm3.mm/m2.day.atm) of the polymer materials in the different polymeric layers with resp. thicknesses I1, I2,... according to OTR=1/ (I1/P1+I2/P2+...)

There are several general types of water permeation measurements that are commonly used, many of these specified as standards by bodies such as ISO, BSI or ASTM. The methods are arbitrarily classified here as Water Vapor Transmission Rate (WVTR) and Gas Permeability, but it is recognized that WVTR measurements can be regarded as a subset of gas permeability techniques. All WVTR methods follow the basic principle of exposing one side of the sample to an elevated level of water vapor and measuring the quantity permeating through the sample.

The present invention provides an electro-conductive back-sheet comprising an aluminum layer and a cold sprayed metal layer.

The metal used in the metal layer according to the present invention includes but is not limited to copper, tin, silver or nickel, or mixtures of two or more thereof or alloys of two or more thereof. Preferably the metal used as metal layer is copper (Cu).

The thickness of the cold sprayed metal layer is in the range of 500nm-50µm. More preferably the thickness of the metal layer is in the range from 1µm-20µm, still more preferably in the range from 5µm-10µm. The aluminum layer preferably has a thickness in the range of in the range of 20µm-200µm. More preferably the aluminum layer has a thickness in the range of 30µm-70µm. The metal layer is applied on top of the aluminum layer via cold spray. Cold spray means that powder particles (typically 5 to 20 µm) are accelerated to very high velocities (200 to 1200 m.s⁻¹) by a supersonic compressed gas jet at temperatures below their melting point. Upon impact with a substrate, the particles experience extreme and rapid plastic deformation which disrupts the thin surface oxide films that are present on all metals and alloys. This allows intimate conformal contact between the exposed metal surfaces under high local pressure, permitting bonding to occur and thick layers of deposited material to be built up rapidly.

This cold spray process is for example disclosed in WO-A-2014182165. In one embodiment, the metal layer is cold sprayed under atmospheric conditions at typically room temperature. In comparison with a prior art vacuum technology, a cold spray method is relatively simple, less time consuming and lower in cost. In this way, the process is also suitable for application of a contact layer to the aluminum exposed at the contacts for the junction box. Here the contact layer is required to make soldering of the tabbing for the junction box possible. In another embodiment, the cold spraying comprises positioning an outlet of a spraying device at the location of each contacting area of the aluminum layer that corresponds to the location of the corresponding electrical contact on the at least one solar cell. As a result, the process allows to create patches only at predetermined locations on the aluminum layer of the back sheet. In a further embodiment, the positioning of the outlet of the spraying device is done by a positioning robot. Advantageously, this allows a cold spray process to be automated and to be implemented in high volume production facilities.

In the present invention, the electro-conductive back-sheet comprises a cold sprayed metal layer on the aluminum layer, i.e., a powder of the metal is mixed with a gas flow and sprayed at high flow rate and at relatively low temperature on the surface of the aluminum layer. The term "low temperature" is defined as a temperature well below melting temperature of the aluminum and the metal to avoid damage to the aluminum. The term "high flow rate" is defined as the rate necessary to crush or breakthrough the oxide layer on the aluminum layer and to deform the particles in such a way that a compact dense layer is formed. Typical flow-rates are 0.5-2 m³/min with a working gas pressure of 0.5-1.0 MPa and a heating power between 3 and 5 kW.

The cold sprayed metal layer can be applied on the aluminum layer locally as contact patches, stripes or lines, to the front of the aluminum layer for the cell interconnection and to the rear of the aluminum layer for the junction box tabbing. The cold sprayed metal layer is preferably applied over the whole surface of the aluminum layer to the front of the aluminum layer for the cell interconnection.

The thermoplastic polymers used in the back-sheet are selected from the group consisting of polyolefins, polyamides, polyesters, fluorinated polymers, or combinations thereof. Preferably the polymers are selected from polyolefins and/ or polyamides and/or polyesters.

Examples of polyamides are PA46, PA6, PA66, PA MXD6, PA610, PA612, PA10, PA810, PA106, PA1010, PA1011, PA1012, PA1210, PA1212, PA814, PA1014, PA618, PA512, PA613, PA813, PA914, PA1015, PA11, PA12. The naming of the polyamides corresponds to the international standard, the first number(s) giving the number of carbon atoms of the starting diamine and the last number(s) the number of carbon atoms of the dicarboxylic acid. If only one number is mentioned, this means that the starting material was aminocarboxylic acid or the lactam derived therefrom. Reference is made to H. Domininghaus, Die Kunststoffe and ihre Eigenschaften [The polymers and their properties], pages 272 ff., VDI-Verlag, 1976.) Also suitable are polyphthalamides or PPAs such as PA4T, PA4T6T, PA66/6T, PA6/6T, PA6T/MPMDT (MPMD stands for 2-methylpentamethylenediamine), PA9T, PA10T, PA11T, PA12T, PA14T and copolycondensates of these latter types with an aliphatic diamine and an aliphatic dicarboxylic acid or with aminocarboxylic acid or a lactam. Blends of the above stated polyamides may also be used.

Examples of polyolefins are ethylene or propylene homo-and copolymers such as polyethylene or polypropylene. The polypropylene may in principle be of any customary commercial polypropylene type, such as an isotactic or syndiotactic homo-or copolymer. The copolymer can be a random-or block-copolymer. The polyolefins can be prepared by any known process, as for example by the Ziegler-Natta method or by means of metallocene catalysis. It is possible to combine the polyolefins with an impact-modifying component, for example a rubber such as EPM rubber or EPDM rubber or SEBS. Optionally the polyolefins are functionalized with functional groups such as maleic anhydride grafted polyethylene or maleic anhydrate grafted polypropylene.

Also flexible polypropylene (FPP) being mechanical or reactor blends of polypropylene (homo or copolymer) with EPR rubber (ethylene propylene rubber) are possible. Examples of such reactor blends are Hifax CA 10 A, Hifax CA 12, Hifax CA7441A, supplied by LyondellBasell, or thermoplastic vulcanizates blends like Santoprene. Such thermoplastic vulcanizates are based on blend of polypropylene with EPDM rubber which are partly crosslinked. Examples of mechanical blends are blends of polypropylene with elastomers such as Versify 2300.01 or 2400.01 (supplied by Dow) Another type of mechanical blend is polypropylene with LLDPE (linear low densitiy polyethylene) or VLDPE (very low density polyethylene) plastomers (like Queo 0201 or Queo 8201 supplied by Borealis Plastomers), or copolymers of Ethylene with a polar co-monomer such as vinyl acetate or alkyl acrylates.

Examples of thermoplastic polyesters include linear thermoplastic polyesters such as polyethylene terephthalate (PET), polypropylene terephthalate (PPT), polybutylene terephthalate (PBT), polyethylene 2,6-naphthalate (PEN), polypropylene 2,6-naphthalate (PPN) and polybutylene 2,6-naphthalate (PBN).

Examples of fluorinated polymers are polyvinyl fluoride (PVF), polyvinylidene fluoride (PVDF) or polytetrafluoroethylene (PTFE).

The polymeric layers in the electro-conductive back-sheet may comprise additives known the art. Preferably the polymer layers comprise at least one additive selected from UV stabilizers, UV absorbers, anti-oxidants, thermal stabilizers and/or hydrolysis stabilizers. When such additives stabilizers are used, a polymeric layer may comprise from 0.05-10 wt.% more preferably from 1- 5 wt.%, based on the total weight of the polymer.

White pigments such as talc, mica, TiO2, ZnO or ZnS may be added to the to one or more polymeric layers of the electro-conductive back-sheet to increase backscattering of sunlight leading to increased efficiency of the PV module. Black pigments such as carbon black or iron oxide may be added for esthetic reasons but aslo for UV adsorption.

Preferably the back-sheet is a multilayer back-sheet comprising a polyamide layer and a polypropylene layer. More preferably it further comprises a polyethylene layer.

Normally a back-sheet comprises a functional layer facing the cells, a structural reinforcement layer, a weather-resistant layer and an adhesive layer between the functional layer and the structural reinforcement layer and/or between the structural reinforcement layer and the weather- resistant layer.

The functional layer facing the cells preferably comprises a polyethylene (PE) alloy such as a blend of polyethylene and an ethylene copolymer. Preferably the polyethylene comprises polar co-monomers such as vinyl acetate, acrylic and methacrylic ester such as methylacrylate, ethylacrylate, butylacrylate or ethylhexylacrylate. The functional layer may comprise inorganic fillers or additives. Preferred inorganic fillers are titanium dioxide or zinc oxide. The functional layer may comprise from 0.05-20 wt.% inorganic filler and or additives, more preferably to 5-10 wt.% inorganic filler and/or additives based on the total weight of the polymers in the layer.

The weather-resistant layer comprises for example a polyamide or a F-containing polymer such as PTFE, PVF or PVDF. The polyamide is preferably chosen from PA46, PA6, PA66, PA MXD6, PA610, PA612, PA10, PA810, PA106, PA1010, PA1011, PA1012, PA1210, PA1212, PA814, PA1014, PA618, PA512, PA613, PA813, PA914, PA1015, PA11 or PA12. The weather-resistant layer may further comprise titanium dioxide or barium sulfate, a UV stabilizer and a heat stabilizer.

The adhesive layer comprises polyurethane, acrylate-based polymers or polyolefins. Examples of polyolefins are maleic anhydride grafted polyolefin such as maleic anhydride grafted polyethylene or polypropylene, an ethylene-acrylic acid copolymer or an ethylene-acrylic ester-maleic anhydride terpolymer. Preferably, the adhesive layer comprises maleic anhydride grafted polyolefin such as a maleic anhydride grafted polyethylene, or a maleic anhydrate grafted polypropylene.

The structural reinforcement layer is for example an engineering plastic such as polypropylene or an alloy of polypropylene or modified polypropylene, a FPP, a polyester such as PET or a polyamide as described above.

All the different layers in the electro-conductive back-sheet may comprise inorganic fillers or additives. Preferred inorganic fillers are titanium dioxide, zinc oxide or talc. The layers may comprise from 0.05-20 wt.% inorganic filler and or additives, more preferably from 5-15 wt.% inorganic filler and/or additives based on the total weight of the polymers in the different layers.

The present invention also relates to a process for the manufacturing of the electro-conductive back-sheet according to the present invention.
In one embodiment, the electro-conductive back-sheet can be manufactured via the following steps:
(a) providing the aluminum layer and a metal that is cold sprayed on the aluminum layer
(b) providing a polymeric back sheet comprising one or more polymeric layer(s) such that the back-sheet has an OTR of at least 20 cm3 /m2.atm per day
(c) extrusion/lamination or adhesion of the aluminum coated metal layer and the polymeric back sheet.
In step a) the metal can be cold sprayed on the aluminum at one side or at both sides of the aluminum layer resulting in the following possible configurations: backsheet-metal-aluminum-metal or backsheet-aluminum-metal. Preferably the metal is sprayed at one side of the aluminum to result in a backsheet-aluminum-metal configuration. In step b) the polymeric layers can be laminated, extrusion laminated or co-extruded. Preferably the polymeric layers are co-extruded.
In another embodiment, the electro-conductive back sheet can be manufactured via the following steps:
(a) providing the aluminum layer on the polymeric back sheet having an OTR of at least 20 cm3/m2.atm per day via extrusion/lamination
(b) cold spraying the metal layer on the aluminum containing polymeric back sheet.

Both above described embodiments may further comprise a patterning step. The cold sprayed metal layer preferably comprises a pattern. Such pattern can be obtained through known patterning technologies. Examples of known patterning technologies given as an indication without being limiting are mechanical milling, chemical etching, laser ablation and die cutting. Laser ablation, mechanical milling or die cutting are preferably used.

The present invention further relates to a photovoltaic module comprising the electro-conductive back-sheet according to the present invention. A photovoltaic module (abbreviated PV module) comprises at least the following layers in order of position from the front sun-facing side to the back non-sun-facing side: (1) a transparent pane (representing the front sheet), (2) a front encapsulant layer, (3) a solar cell layer, (4) a back encapsulant layer, and (5) the electro-conductive back-sheet according to the present invention, representing the rear protective layer of the module.

The front sheet is typically a glass plate or especially for flexible modules a layer of fluorinated polymers like ETFE (ethylene tetrafluoroethylene) or PVDF (polyvinylidene fluoride).

The front and back encapsulant used in solar cell modules are designed to encapsulate and protect the fragile solar cells. The "front side" corresponds to a side of the photovoltaic cell irradiated with light, i.e. the light-receiving side, whereas the term "backside" corresponds to the reverse side of the light-receiving side of the photovoltaic cells.

Suitable polymer materials for solar cell encapsulants typically possess a combination of characteristics such as high impact resistance, high penetration resistance, good ultraviolet (UV) light resistance, good long term thermal stability, adequate adhesion strength to glass and/or other rigid polymeric sheets, high moisture resistance, and good long-term weather ability. Currently, ethylene/vinyl acetate copolymers are the most widely used encapsulants.

The photovoltaic module comprising the electro-conductive back-sheet according to the present invention surprisingly provides more stability, durability and can be manufactured cheaper. Moreover, the photovoltaic module shows a good module output even if a polymeric back-sheet is used with an OTR of at least 20 cm3/m2.atm per day

The present invention further relates to a method for manufacturing a photovoltaic module with a stack comprising at least one solar cell, a back-sheet and a junction box, comprising:
- providing the at least one solar cell being arranged as a back contacted solar cell with a front surface for receiving radiation and a rear surface provided with electrical contacts;
- providing the electro-conductive back-sheet according to the present invention;
- patterning the conductive surface
- placing the at least one solar cell with the rear surface facing the patterned conductive surface;
- conductively contacting either each electrical contact of the at least one solar cell with a corresponding one of the contacting areas by an electro-conductive adhesive.

The present invention will now be described in detail with reference to the following non-limiting examples which are by way of illustration only.

### FIGURES

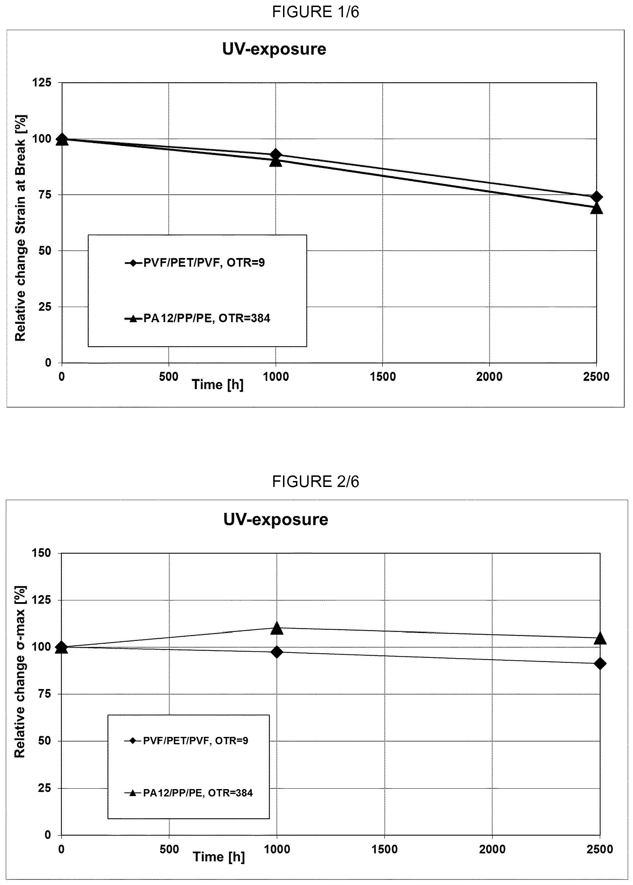

Figure 1 shows the relative change of strain at break in % of back-sheets with different OTR values under UV exposure over time.
Figure 2 shows the relative change of δ max in % of back-sheets with different OTR values under UV exposure over time.
Figure 3 shows the relative change of strain at break in % of back-sheets with different OTR values at Damp heat 85°C/85% RH over time.
Figure 4 shows electrochemical analysis of the oxidation sensitivity of neat metal foils established in a 3-electrode set up via a stepwise dissolution measurement (Procedure in described in Metrohm Autolab application note COR08). A high cumulative charge corresponds to an increased overall oxidation rate.
Figure 5 refers to a backsheet with high OTR and shows good mechanical performance after 2000hrs hydrolytic ageing.
Figure 6 refers to a backsheet with low OTR and shows bad mechanical performance after 2000hrs hydrolytic ageing.

### EXAMPLES

### Example 1

Oxygen permeation measurements of thermoplastics polymeric layers in formulated back-sheets are performed according to ASTM D 3985 with a MOCON OX-Tran 2/21 at 38°C, 0% RH, area of the back-sheet samples 50 cm2. These measurements are done in duplo. Results are given in table 1.

Water permeation measurements of thermoplastics polymeric layers in formulated back-sheets. are performed according to ASTM F 1249 with a MOCON Permatran-W700 at 38°C, 90% RH- 0% RH. These measurements are done in duplo.

Results are given in table 2.

**Table 1: Oxygen Permeation Data**

| Material Back-sheet | Thickness (µm) | OTR cm3/(m2 - day).atm | Permeation cm3 - mm/m2.day.atm |
|---|---|---|---|
| PA12-PP-PE | 386.2 | 384.9 | 148.6 |
| PA12-PP-PE | 389.4 | 384.1 | 149.6 |
| PA12-PP | 369.7 | 353.0 | 130.5 |
| PA12-PP | 371.9 | 355.0 | 132.0 |
| PET | 1142 | 2.74 | 3.13 |
| PVF-PET-PVF | 350.0 | 9.12 | 3.19 |
| FPP*-PA6-PE | 342.8 | 46.3 | 15.9 |
| PE-PA6-PP | 348.0 | 44.9 | 15.6 |

| | | | |
|---|---|---|---|
| *FPP=Flexible PP | | | |

**Table 2: Water vapor Permeation Data**

| Material Back-sheet | Vapour Transmission rate | Thickness | Coefficient of permeability | Average |
|---|---|---|---|---|
| | g/[m²-day] | mm | [g-mm]/[m²-day] | [g-mm]/[m²-day] |
| PA12-PP-PE | 0.815 | 0.3795 | 0.309 | 0.310 |
| PA12-PP-PE | 0.817 | 0.3808 | 0.311 | |
| PA12-PP | 0.736 | 0.3781 | 0.278 | 0.281 |
| PA12-PP | 0.774 | 0.3658 | 0.283 | 0.281 |
| PVF-PET-PVF | 2.132 | 0.3556 | 0.758 | 0.758 |

### Example 2.

Power output performance is measured on 2x2 mini-modules at 500 hrs damp heat ageing (85%RH; 85°C), comprising the below indicated electro-conductive back-sheets.

Current (I) and Voltage (V) characteristics of the solar cells prior to module manufacturing are measured using SUNSIM flash-tester and the IV characteristics of the modules are measured using a Pasan III A flash-tester under standard testing conditions [1000W/m², AM1.5 spectrum].

FF [%] is a parameter which, in conjunction with V_{oc} and I_{sc}, determines the maximum power from a solar cell. The FF is defined as the ratio of the maximum power from the solar cell to the product of V_{oc} and I_{sc}.

In table 3 results are shown for electro-conductive backsheets based on pure metallic copper (Cu) with high and low OTR and based on physical vapor deposited (PVD) copper on aluminum (Al/Cu PVD) with high OTR.

**Table 3**

| Conductive back-sheet | OTR cm3/m2.atm per day / back-sheet | Pm [W] Max power | Isc [A] | Voc [V] | FF [%] | Cell eff [%] |
|---|---|---|---|---|---|---|
| PA12-PP-PE-Cu | 384 | -0.3% | 0.6% | -0.1% | -0.9% | -0.4% |
| PA12-PP-PE-Cu | | -0.8% | 0.6% | -0.1% | -1.2% | -0.8% |
| PA12-PP-PE-Cu | | -1.0% | 0.8% | -0.1% | -1.6% | -0.9% |
| PA12-PP-PE-Cu | | -0.7% | 0.8% | -0.1% | -1.4% | -0.7% |
| PVF-PET-PVF-Cu. | 9 | 0.8% | 0.5% | -0.2% | 0.5% | 0.9% |
| PVF-PET-PVF-Cu | | 0.7% | 0.6% | -0.2% | 0.3% | 0.7% |
| PVF-PET-PVF-Cu | | 0.8% | 0.7% | -0.2% | 0.3% | 0.7% |
| PVF-PET-PVF-Cu | | 0.8% | 0.7% | -0.1% | 0.2% | 0.8% |
| PA12-PP-PE-Al/Cu PVD | 384 | -13% | 0.1% | 0.0% | -13% | -13% |
| PA12-PP-PE-Al/Cu PVD | | -15% | 0.2% | -0.1% | -15% | -15% |
| PA12-PP-PE-Al/Cu PVD | | -18% | 0.0% | -0.1% | -18% | -18% |
| PA12-PP-PE Al/Cu PVD | | -19% | 0.1% | 0.1% | -19% | -19% |

The results in Table 3 show that replacing pure metallic copper in electro-conductive backsheets with high OTR by Al/Cu PVD results in very and too high-power decay (>5%) already after 500 hrs dampheat ageing.

### Example 3

Power output performance was measured of 2x2 mini-modules after 1000 hrs damp heat ageing (85%RH; 85°C) comprising the below indicated electro-conductive back-sheets. The copper layer is applied either via PVD (Al/Cu PVD) or via cold spray (Cs) (Al/Cu Cs).

IV-characteristics (current- voltage) are measured. Results are given in table 4.

**Table 4**

| Conductive back-sheet | OTR cm3/m2.atm per day / back-sheet | Pm [W] | Isc [A] | Voc[V] | FF [%] | Cell eff[%] |
|---|---|---|---|---|---|---|
| PVF-PET-PVF-Al/Cu PVD | 9 | -1.9% | +1.0% | +0.2% | -3.0% | -1.9% |
| PVF-PET-PVF-Al/Cu PVD | | -4.4% | +1.2% | +0.2% | -5.7% | -4.4% |
| PVF-PET-PVF-Al/Cu PVD | | -1.4% | +1.2% | +0.2% | -2.8% | -1.4% |
| PVF-PET-PVF-Al/Cu PVD | | -4.6% | +1.0% | +0.2% | -5.6% | -4.6% |
| PVF-PET-PVF-Al/Cu Cs | 9 | -0.5% | +1.0% | +0.2% | -1.6% | -0.5% |
| PVF-PET-PVF-Al/Cu Cs | | -1.3% | +0.5% | +0.2% | -1.9% | -1.3% |
| PVF-PET-PVF-Al/Cu Cs | | -0.0% | +1.1% | +0.3% | -1.3% | -0.0% |
| PA12-PP-Al/Cu PVD | 353 | -7.6% | +0.8% | +0.2% | -8.6% | -7.7% |
| PA12-PP-Al/Cu PVD | | -6.8% | +0.8% | +0.1% | -7.7% | -6.8% |
| PA12-PP-Al/Cu PVD | | -8.0% | +0.6% | +0.1% | -8.6% | -8.0% |
| PA12-PP-Al/Cu Cs | 353 | +0.4% | +0.6% | +0.2% | -0.4% | +0.4% |
| PA12-PP-Al/Cu Cs | | -0.1% | +0.8% | +0.2% | -1.0% | -0.1% |
| PA12-PP-Al/Cu Cs | | -0.2% | +0.7% | +0.1% | -1.0% | -0.2% |

Table 4 indicates that electro-conducive backsheets with low OTR based on cold spray deposited copper on aluminum outperform PVD copper deposited aluminum. The results in Table 4 confirm the result of example 3, i.e. electro-conductive backsheets with high OTR based on PVD deposited copper on aluminum result in too high-power decay (>5%). However, it also shown that electro-conductive backsheets with high OTR based on cold spray deposited copper on aluminum show excellent performance in dampheat ageing.

### Example 4

Power output performance was measured of 2x2 mini-modules after 3000 hrs damp heat ageing (85%RH; 85°C) comprising the below indicated electro-conductive back-sheets. The copper layer is applied via cold spray (Cs).

IV-characteristics (current- voltage) are measured. Results are given in table 5.

**Table 5**

| Conductive back-sheet | OTR cm3/m2.atm per day / back-sheet | Pm [W] | Isc [A] | Voc[V] | FF [%] | Cell eff[%] |
|---|---|---|---|---|---|---|
| PA12-PP-Al/Cu Cs | 353 | -1.3% | +0.7% | +0.1% | -2.1% | -1.3% |
| PA12-PP-Al/Cu Cs | | -1.7% | +0.2% | -0.1% | -1.8% | -1.7% |
| PA12-PP-Al/Cu Cs | | -0.5% | +0.8% | 0.0% | -1.4% | -0.5% |

Table 5 shows that that electro-conductive backsheets with high OTR based on cold spray deposited copper on aluminum show excellent performance even after 3000 hrs dampheat ageing (<<5% power decay).

### Example 5

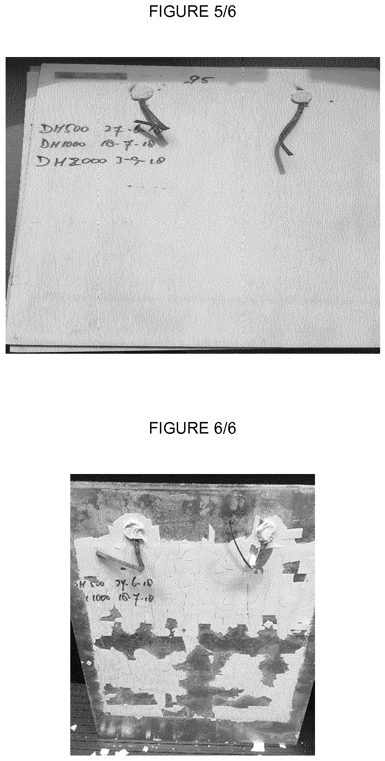

Power output performance was measured of 2x2 mini-modules from 0 to 2500 hrs hydrolytic ageing (95%RH; 85°C) comprising the below indicated electro-conductive back-sheets. The copper layer is applied via cold spray (Cs). The average power decay of 4 modules of the same built is indicated as function of hydrolytic ageing time in table 6. Moreover, table 6 also refers to the figures 5 and 6 of the modules of each built after 2000 hrs hydrolytic ageing.

**Table 6**

| Conductive back-sheet | OTR cm3/m2.atm per day / back-sheet | Power [%] t=500 | Power [%] t=1000 | Power [%] t=1500 | Power [%] t=2000 | Power [%] t=2500 |
|---|---|---|---|---|---|---|
| PA12-PP-Al/Cu Cs | 353 | +1.0% | +1.3% | +0.6% | +0.3% | -0.8% |
| PET-Al/Cu Cs | 3 | +1.3% | +0.8% | +0.0% | -1.4% | -3.8% |

| Conductive back-sheet | OTR | | | | | |
|---|---|---|---|---|---|---|
| | cm3/m2.atm per day / Back-sheet | Figures 5 and 6 show one of the modules after 2000 hrs hydrolytic ageing | | | | |
| PA12-PP-Al/Cu Cs | 353 | Backsheet shows good mechanical performance after 2000hrs (Fig. 5) | | | | |
| PET-Al/Cu Cs | 3 | Backsheet loses its mechanical integrity after 2000hrs (Fig. 6) | | | | |

Table 6 shows that electro-conductive backsheets with high OTR based on cold spray deposited copper on aluminum outperform electro-conductive backsheets with low OTR based on cold spray deposited copper on aluminum. Table 6 clearly indicates that this is caused by the much better mechanical performance of electro-conductive backsheets with high OTR in hydrolytic ageing (as also shown in figure 6), i.e. the low OTR backsheet based on PET completely loses its mechanical integrity after 2000 hrs resulting in a strong increase in power decay.

## Claims

1. Electro-conductive polymeric back-sheet for back-contact photovoltaic cells comprising an aluminum layer, a cold sprayed metal layer on top of the aluminum layer, and a polymeric back-sheet, **characterized in that** the polymeric back-sheet has an oxygen transmission rate (OTR) of at least 20 cm³/m².atm per day.

2. Electro-conductive polymeric back-sheet according to claim 1, wherein the metal is chosen from the group consisting of copper, tin or nickel, mixtures of two or more thereof, and alloys of two or more thereof.

3. Electro-conductive polymeric back-sheet according to any one of the claims 1-2, wherein the cold sprayed metal layer is copper.

4. Electro-conductive polymeric back-sheet according to claim any one of the claims 1-3, wherein the polymeric back-sheet has an (OTR) of at least 40 cm³/m².atm per day.

5. Electro-conductive polymeric back-sheet according to claim any one of the claims 1-3, wherein the polymeric back-sheet has an (OTR) of at least 60 cm³/m².atm per day.

6. Electro-conductive polymeric back-sheet according to claim any one of the claims 1-3, wherein the polymeric back-sheet has an (OTR) of at least 240 cm³/m².atm per day.

7. Electro-conductive polymeric back-sheet according to claim 1 wherein the cold sprayed metal layer has a thickness in the range of 1 µm - 50 µm.

8. Electro-conductive polymeric back-sheet according to any one of the claims 1-7, wherein the polymeric back-sheet comprises more than one thermoplastic polymer layer chosen from the group selected of polyolefins, polyamides, polyesters, and fluorinated polymers.

9. Electro-conductive polymeric back-sheet according to any one of the claims 1-8, wherein the polymeric back-sheet is a multilayer back-sheet comprising at least a polyamide layer and a polypropylene layer.

10. Electro-conductive polymeric back-sheet according to claim 9, wherein the polymeric back-sheet further comprises a polyethylene layer.

11. Process for the manufacturing of an electro-conductive back-sheet according to any one of the claims 1-10, comprising the steps of:
(a) providing an aluminum layer and a metal that is cold sprayed on the aluminum layer to provide an aluminum coated metal layer,
(b) providing a polymeric back-sheet comprising one or more polymeric layer(s), and
(c) laminating the aluminum coated metal layer and the polymeric back-sheet.

12. Process for the manufacturing of an electro-conductive back-sheet according to any one of the claims 1-10, comprising the steps of:
(a) providing the aluminum layer on the polymeric back sheet via extrusion/lamination, wherein the polymeric back-sheet comprises one or more polymeric layer(s), and
(b) cold spraying the metal layer on the aluminum layer.

13. Process for the manufacturing of an electro-conductive back-sheet according to claim 11 or 12, wherein the one or more polymeric layer(s) in the polymeric back-sheet are co-extruded and/or laminated.

14. Process for the manufacturing of an electroconductive back-sheet according to claims 11 or 12, wherein the metal layer is cold sprayed locally.

15. Process for the manufacturing of an electro-conductive back-sheet according to any one of the claims 11-14, further comprising the step of patterning the electro-conductive back-sheet.

16. Photovoltaic module comprising the electro-conductive back-sheet according to any one of the claims 1-10.

## Patentansprüche

1. Elektrisch leitfähige Polymerrückseitenfolie für Rückseitenkontakt-Photovoltaikzellen, die eine Aluminiumschicht, eine kaltgespritzte Metallschicht auf der Aluminiumschicht und eine Polymerrückseitenfolie umfasst, **dadurch gekennzeichnet, dass** die Polymerrückseitenfolie eine Sauerstofftransportrate (oxygen transmission rate - OTR) von wenigstens 20 cm³/m².atm pro Tag aufweist.

2. Elektrisch leitfähige Polymerrückseitenfolie nach Anspruch 1, wobei das Metall aus der Gruppe gewählt ist, die aus Kupfer, Zinn oder Nickel, Mischungen aus zwei oder mehr davon und Legierungen aus zwei oder mehr davon besteht.

3. Elektrisch leitfähige Polymerrückseitenfolie nach einem der Ansprüche 1-2, wobei die kaltgespritzte Metallschicht Kupfer ist.

4. Elektrisch leitfähige Polymerrückseitenfolie nach einem der Ansprüche 1-3, wobei die Polymerrückseitenfolie eine (OTR) von wenigstens 40 cm³/m².atm pro Tag aufweist.

5. Elektrisch leitfähige Polymerrückseitenfolie nach einem der Ansprüche 1-3, wobei die Polymerrückseitenfolie eine (OTR) von wenigstens 60 cm³/m².atm pro Tag aufweist.

6. Elektrisch leitfähige Polymerrückseitenfolie nach einem der Ansprüche 1-3, wobei die Polymerrückseitenfolie eine (OTR) von wenigstens 240 cm³/m².atm pro Tag aufweist.

7. Elektrisch leitfähige Polymerrückseitenfolie nach Anspruch 1, wobei die kaltgespritzte Metallschicht eine Dicke in dem Bereich von 1 µm - 50 µm aufweist.

8. Elektrisch leitfähige Polymerrückseitenfolie nach einem der Ansprüche 1-7, wobei die Polymerrückseitenfolie mehr als eine Thermoplastschicht umfasst, die aus der Gruppe gewählt ist, die aus Polyolefinen, Polyamiden, Polyestern und fluorierten Polymeren ausgewählt ist.

9. Elektrisch leitfähige Polymerrückseitenfolie nach einem der Ansprüche 1-8, wobei die Polymerrückseitenfolie eine mehrschichtige Rückseitenfolie ist, die wenigstens eine Polyamidschicht und eine Polypropylenschicht umfasst.

10. Elektrisch leitfähige Polymerrückseitenfolie nach Anspruch 9, wobei die Polymerrückseitenfolie ferner eine Polyethylenschicht umfasst.

11. Verfahren für das Anfertigen einer elektrisch leitfähigen Polymerrückseitenfolie nach einem der Ansprüche 1-10, das die folgenden Schritte umfasst:
(a) Bereitstellen einer Aluminiumschicht und eines Metalls, das auf die Aluminiumschicht kaltgespritzt wird, um eine aluminiumbeschichtete Metallschicht bereitzustellen,
(b) Bereitstellen einer Polymerrückseitenfolie, die eine oder mehrere Polymerschicht(en) umfasst, und
(c) Laminieren der aluminiumbeschichteten Metallschicht und der Polymerrückseitenfolie.

12. Verfahren für das Anfertigen einer elektrisch leitfähigen Polymerrückseitenfolie nach einem der Ansprüche 1-10, das die folgenden Schritte umfasst:
(a) Bereitstellen der Aluminiumschicht auf der Polymerrückseitenfolie mittels Extrusion/Laminierung, wobei die Polymerrückseitenfolie eine oder mehrere Polymerschicht(en) umfasst, und
(b) Kaltspritzen der Metallschicht auf die Aluminiumschicht.

13. Verfahren für das Anfertigen einer elektrisch leitfähigen Polymerrückseitenfolie nach Anspruch 11 oder 12, wobei die eine oder die mehreren Polymerschicht(en) in der Polymerrückseitenfolie gemeinsam extrudiert und/oder laminiert werden.

14. Verfahren für das Anfertigen einer elektrisch leitfähigen Polymerrückseitenfolie nach Anspruch 11 oder 12, wobei die Metallschicht lokal kaltgespritzt wird.

15. Verfahren für das Anfertigen einer elektrisch leitfähigen Polymerrückseitenfolie nach einem der Ansprüche 11-14, das ferner den Schritt eines Musterns der elektrisch leitfähigen Polymerrückseitenfolie umfasst.

16. Photovoltaikmodul, das die elektrisch leitfähige Polymerrückseitenfolie nach einem der Ansprüche 1-10 umfasst.

## Revendications

1. Feuille arrière polymère électro-conductrice pour cellules photovoltaïques à contact arrière comprenant une couche d'aluminium, une couche métallique pulvérisée à froid sur le dessus de la couche d'aluminium, et une feuille arrière polymère, **caractérisée en ce que** la feuille arrière polymère présente un taux de transmission d'oxygène (OTR) d'au moins 20 cm³/m².atm par jour.

2. Feuille arrière polymère électro-conductrice selon la revendication 1, dans laquelle le métal est choisi dans le groupe constitué du cuivre, de l'étain ou du nickel, des mélanges de deux ou plus de ceux-ci, et des alliages de deux ou plus de ceux-ci.

3. Feuille arrière polymère électro-conductrice selon l'une quelconque des revendications 1 à 2, dans laquelle la couche métallique projetée à froid est du cuivre.

4. Feuille arrière polymère électro-conductrice selon l'une quelconque des revendications 1 à 3, dans laquelle la feuille arrière polymère présente un (OTR) d'au moins 40 cm³/m².atm par jour.

5. Feuille arrière polymère électro-conductrice selon l'une quelconque des revendications 1 à 3, dans laquelle la feuille arrière polymère présente un (OTR) d'au moins 60 cm³/m².atm par jour.

6. Feuille arrière polymère électro-conductrice selon l'une quelconque des revendications 1 à 3, dans laquelle la feuille arrière polymère présente un (OTR) d'au moins 240 cm³/m².atm par jour.

7. Feuille arrière polymère électro-conductrice selon la revendication 1, dans laquelle la couche métallique pulvérisée à froid présente une épaisseur comprise entre 1 µm et 50 µm.

8. Feuille arrière polymère électro-conductrice selon l'une quelconque des revendications 1 à 7, dans laquelle la feuille arrière polymère comprend plus d'une couche de polymère thermoplastique choisie dans le groupe choisi parmi les polyoléfines, les polyamides, les polyesters et les polymères fluorés.

9. Feuille arrière polymère électro-conductrice selon l'une quelconque des revendications 1 à 8, dans laquelle la feuille arrière polymère est une feuille arrière multicouche comprenant au moins une couche de polyamide et une couche de polypropylène.

10. Feuille arrière polymère électro-conductrice selon la revendication 9, dans laquelle la feuille arrière polymère comprend en outre une couche de polyéthylène.

11. Procédé de préparation de la feuille arrière électro-conductrice selon l'une quelconque des revendications 1 à 10, comprenant les étapes consistant à :
(a) fournir une couche d'aluminium et un métal qui est pulvérisé à froid sur la couche d'aluminium pour fournir une couche métallique revêtue d'aluminium,
(b) fournir une feuille arrière polymère comprenant une ou plusieurs couches polymères, et
(c) le laminage de la couche métallique revêtue d'aluminium et de la feuille arrière polymère.

12. Procédé de préparation d'une feuille arrière électro-conductrice selon l'une quelconque des revendications 1 à 10, comprenant les étapes consistant à :
(a) fournir la couche d'aluminium sur la feuille arrière polymère par extrusion/laminage, la feuille arrière polymère comprenant une ou plusieurs couches polymères, et
(b) la pulvérisation à froid de la couche métallique sur la couche d'aluminium.

13. Procédé de fabrication d'une feuille arrière électro-conductrice selon la revendication 11 ou 12, dans lequel la ou les couches polymères dans la feuille arrière polymère sont co-extrudées et/ou laminées.

14. Procédé de fabrication d'une feuille arrière électro-conductrice selon les revendications 11 ou 12, dans lequel la couche métallique est pulvérisée à froid localement.

15. Procédé de fabrication d'une feuille arrière électro-conductrice selon l'une quelconque des revendications 11 à 14, comprenant en outre l'étape de formation de motifs sur la feuille arrière électro-conductrice.

16. Module photovoltaïque comprenant la feuille arrière électro-conductrice selon l'une quelconque des revendications 1 à 10.
